# EUROPEAN PATENT SPECIFICATION

(11) **EP 0 609 501 B1**
(45) Date of publication and mention of the grant of the patent: **15.09.1999**
(21) Application number: 93118141.6
(22) Date of filing: 09.11.1993
(51) Int. Cl.: H01L 23/532, H01L 21/768

(54) **Aluminium based metallization for semiconductor device**
Metallisierung auf Aluminiumbasis für Halbleiterbauelement
Métallisation basé sur l'aluminium pour dispositif semi-conducteur

(30) Priority: 20.01.1993 JP 750593
(43) Date of publication of application: 10.08.1994
(73) Proprietor: KABUSHIKI KAISHA TOSHIBA, Kawasaki-shi, Kanagawa-ken 210-8572 (JP)
(72) Inventor: Egawa, Hidemitsu, c/o Intellectual Property Div., Tokyo 105 (JP)
(74) Representative: Lehn, Werner, Dipl.-Ing.

(56) References cited:
- PATENT ABSTRACTS OF JAPAN vol. 11, no. 325 (E-551) 22 October 1987 & JP-A-62 114 241 (FUJITSU LTD)
- RELIABILITY PHYSICS, April 1975, LAS VEGAS,USA pages 151 - 158 SCOGGAN ET AL 'Width dependence of electromigratin life in Al-Cu, Al-Cu-Si and Ag conductors'
- PATENT ABSTRACTS OF JAPAN vol. 14, no. 268 (E-939) 26 March 1990 & JP-A-02 084 719 (NEC CORP)
- PROCEEDINGS OF THE FOURTH INTERNATIONAL IEEE VLSI MULTILEVEL INTERCONNECTION CONFERENCE, June 1987, SANTA CLARA,USA pages 456 - 462 KWOK 'Effects of grain growth and grain structure on electromigration lifetime in Al-Cu submicron interconects'

## Description

The present invention relates to a semiconductor device comprising a semiconductor device comprising wiring lines formed from an electrode wiring layer using, as an electrode material, an Aℓ alloy containing Cu.

Such a device is discussed in the Proc. of the 4th International IEEE VLSI Multilevel Interconnection Conference, June 1987, pp 456 - 459, which also discusses the general problem of electromigration in Aℓ-Cu wirings and its dependence on grain structures.

Aluminum is generally used for an electrode wiring line of a semiconductor device in view of a resistance or workability. For the Aℓ wiring line, a Cu-added Aℓ alloy is generally used to prevent occurrence of an erroneous wiring line mode such as electro-migration or stress-migration, thereby improving reliability.

The Aℓ wiring line having a size of several fm larger than the size of Aℓ crystal generally has a point where three grain boundaries between the Aℓ grains overlap, i.e., a triple point of the grain boundaries.

If a large current having, e.g., a current density of 10⁴ A/cm² or more flows in the wiring line, Aℓ atoms start to diffuse along the grain boundaries, so that the atoms are excess or deficient at the triple points of the grain boundaries to cause disconnection.

This phenomenon is called electro-migration. This is caused because the activation energy of the grain boundary of the Aℓ-Cu alloy is about 1.4 eV while the activation energy of the grain boundary is about 0.6 eV, so that the grain boundary serves as a high-speed diffusion path.

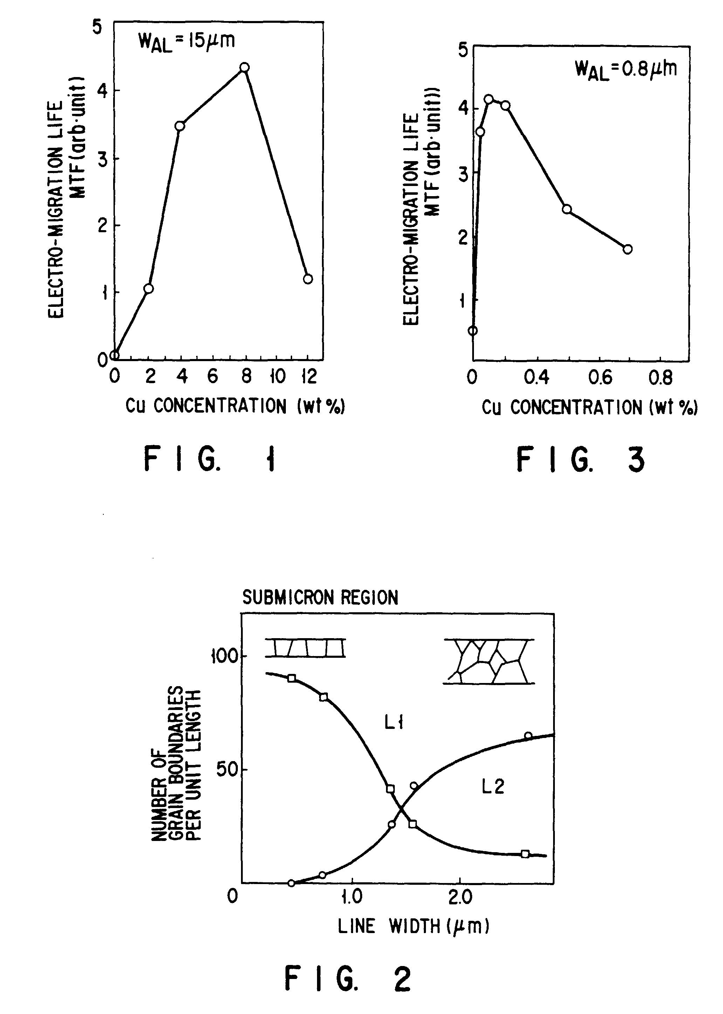

Cu is added to the Aℓ alloy to segregate Cu at the grain boundaries and prevent the Aℓ atoms from diffusing along the grain boundaries. As shown in Fig. 1, the electro-migration life MTF [arb.unit] is prolonged depending on the content of Cu when the Cu concentration is about 8 wt% or less.

In a submicron region in which the wiring line size is 1 fm or less and smaller than the crystal grain size, for example, as shown in Fig. 2, the above-described triple points disappear in the wiring line, leaving bamboo-node-like grain boundaries across the grain size boundaries. More specifically, as the wiring line size becomes larger, the number of triple points of the grain boundaries per unit length is increased, as indicated by a line L2, so that electro-migration tends to occur. On the other hand, as the wiring line size becomes smaller, the number of bamboo-node-like grain boundaries is increased, as indicated by a line L1. The electro-migration life at this time depends on the diffusion speed within the crystal grain, MTF is improved as a whole, and the wiring line life tends to be prolonged. The line L1 represents the number of bamboo-node-like grain boundaries per unit length with respect to the line size, and the line L2 represents the number of triple points of the grain boundaries per unit with respect to the line size.

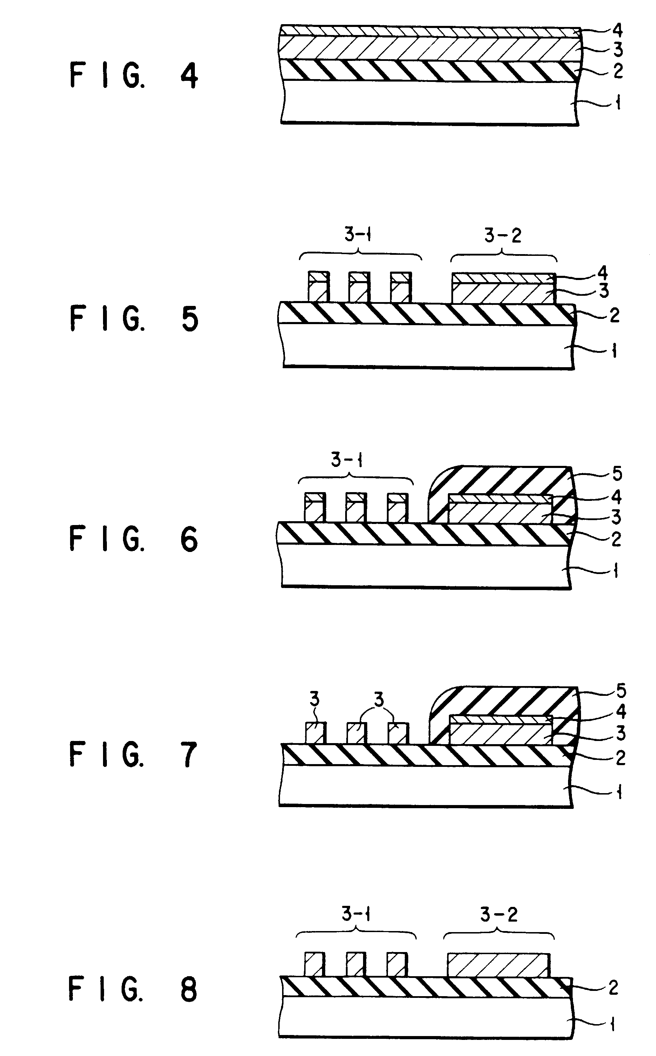

In the wiring line having a size smaller than the grain size, as shown in Fig. 3, MTF is improved when the Cu concentration is about 0.1 wt% or less. If the Cu concentration exceeds 0.1 wt%, MTF is degraded.

That is because Cu is segregated at the grain boundaries when Cu is added exceeding the limit amount for dissolving Cu into Aℓ crystal, and the diffusion speed in the longitudinal direction of the wiring line varies at the grain boundaries where Cu is segregated to cause disconnection.

However, the Cu concentration of the current wiring line is determined by the Cu concentration of a sputtering target or vapor source, so that all the electrode wiring lines formed in the same process have the same Cu concentration. For this reason, the electrode wiring lines having the same Cu concentration are used although each electrode wiring line ranging from a wiring line having a size in the submicron region to be used as a signal line to a wiring line having a size of 10 fm or more to be used as a power line has an optimal Cu concentration for its size. Thus, an optimal resistance to electro-migration for wiring lines having different sizes cannot be obtained.

The present invention has been made to overcome the above drawback, and has as its object to provide a semiconductor device which selects and defines the Cu concentration of the electrode consisting of an Aℓ alloy in accordance with the wiring line size, thereby obtaining an optimal resistance to electro-migration and high reliability.

According to one aspect of the present invention, there is provided a semiconductor device comprising wiring lines formed from an electrode wiring layer using, as an electrode material, an Aℓ alloy containing Cu, characterised in that wiring lines (3-1) having a width smaller than the crystal grain size of the wiring have a Cu concentration of 0.05 to 0.3 wt%, and wiring lines (3-2) having a width larger than the crystal grain size of the wiring have a Cu concentration of 0.5 to 10 wt%.

The present invention also provides a method of forming a semiconductor device, in which wiring lines are formed from an electrode wiring layer using, as an electrode material, an Aℓ alloy containing Cu, characterised in that first wiring lines (3-1) having a width smaller than the crystal grain size of the wiring and having a Cu concentration of 0.05 to 0.3 wt%, are formed in the same formation process as second wiring lines (3-2) having a width larger than the crystal grain size of the wiring and having a Cu concentration of 0.05 to 0.3 wt%, and the Cu concentration of the second wiring lines is then increased to 0.5 to 10 wt% by covering the second wiring lines with a Cu-based material and annealing to cause diffusion of the Cu-based material into the second wiring lines.

With the above arrangement, the semiconductor of the present invention selects and defines the Cu concentration in the Aℓ alloy wiring line in accordance with the wiring line size, thereby obtaining an optimal resistance to electro-migration.

This invention can be more fully understood from the following detailed description when taken in conjunction with the accompanying drawings, in which:
Fig. 1 is a graph showing the Cu concentration dependency of a resistance to electro-migration when an Aℓ-Cu alloy wiring line has a width of 15 fm;
Fig. 2 is a view showing an example of a grain shape in the Aℓ alloy wiring line;
Fig. 3 is a graph showing the Cu concentration dependency of a resistance to electro-migration when an Aℓ-Cu alloy wiring line has a width of 0.8 fm;
Fig. 4 is a partial sectional view showing a step of manufacturing the semiconductor device of the present invention;
Fig. 5 is a partial sectional view showing a step of manufacturing the semiconductor device of the present invention following the step shown in Fig. 4;
Fig. 6 is a partial sectional view showing a step of manufacturing the semiconductor device of the present invention following the step shown in Fig. 5;
Fig. 7 is a partial sectional view showing a step of manufacturing the semiconductor device of the present invention following the step shown in Fig. 6; and
Fig. 8 is a partial sectional view showing a step of manufacturing the semiconductor device of the present invention following the step shown in Fig. 7.

A semiconductor device according to an embodiment of the present invention will be described below with reference to the accompanying drawings.

Figs. 4 to 8 are views showing steps of manufacturing a semiconductor device according to the present invention.

As shown in Fig. 4, an Aℓ-Cu alloy 3 serving as an electrode wiring line is formed on the surface of a semiconductor substrate 1 through an insulating film 2. A Cu-based material 4, e.g., pure Cu is formed on the Aℓ-Cu alloy 3. Although film formation is performed by the sputtering method, the deposition method can be used in place of the sputtering method.

As shown in Fig. 5, the resultant structure constituted by stacking the Aℓ-Cu alloy 3 and the Cu-based material 4 is formed into electrode wiring lines 3-1 and 3-2. More specifically, the wiring line 3-1 having a size smaller than the crystal grain size of the Aℓ-Cu alloy 3 and the wiring line 3-2 having a size larger than the crystal grain size of the Aℓ-Cu alloy 3 are formed to selectively expose the insulating film 2.

As shown in Fig. 6, a resist 5 is covered on a part of the exposed portion of the insulating film 2, and the Cu-based material 4. As shown in Fig. 7, the Cu-based material 4 of the wiring line 3-1 having a size smaller than the crystal grain size of the Aℓ-Cu alloy 3 is selectively removed by exposure and development to expose the thin wiring line 3-1.

On the other hand, the resist 5 is covered on the thick wiring line 3-2.

As shown in Fig. 8, after the resist 5 covered on the thick wiring line 3-2 is removed, annealing is performed, e.g., in a reducing atmosphere. As a result, the Cu-based material 4 of the thick wiring line 3-2 is diffused by using the grain boundaries in the Aℓ-Cu alloy 3 as the main diffusion path to increase the Cu concentration in the Aℓ-Cu alloy 3 of the thick wiring line 3-2. The thick wiring line 3-2 shown in Fig. 8 has a higher Cu concentration than that of the thin wiring line 3-1 by a diffusion amount.

If the Cu concentration of the Aℓ-Cu alloy 3 in this embodiment is set in advance to be equal to that of the final wiring line 3-1 having a size smaller than the crystal grain size, the resistance to electro-migration of the wiring line 3-1 having a size smaller than the crystal grain size can be maximized, as shown in Fig. 3.

In this case, Cu must not be segregated in the Aℓ-Cu alloy 3 of the thin wiring line 3-1. Checking the segregated state of Cu, it was confirmed that Cu was not segregated by annealing when the Cu concentration was 0.3 wt% or less.

It was confirmed by experiments that, in the final product, the Cu concentration of the Aℓ alloy wiring line having a size smaller than the crystal grain size was in a range of 0.05 to 0.3 wt%. Also in the Aℓ-Cu alloy 3 of this embodiment, an optimal resistance to migration was obtained in a range of 0.05 to 0.3 wt% of the Cu concentration.

In the above embodiment, the Cu-based material 4 is first covered on the Aℓ-Cu alloy 3, and then the resultant structure is formed into the electrode wiring lines. However, the Aℓ-Cu alloy 3 may be first formed into a desired electrode wiring line shape, and the Cu-based material 4 may be then covered and diffused.

As has been described with reference to Figs. 7 and 8, the Cu-based material is preferably annealed in the reducing atmosphere. However, annealing may be performed in an inert gas atmosphere as of N2 and Ar.

If annealing was performed in the reducing atmosphere, a Cu oxide film was found to be used as the Cu-based material.

In the above embodiment, the wiring line 3-2 having a size larger than the crystal grain size can obtain an optimal resistance to electro-migration at the Cu concentration of about 8 wt%. On the other hand, Cu must be segregated at the triple points where the grain boundaries in the Aℓ-Cu alloy 3 overlap. It was confirmed that segregation was caused at the Cu concentration of 0.5 wt% or more by annealing.

The Cu concentration of 8 wt% or more only causes degradation of the resistance to electro-migration. Therefore, the optimal range of the Cu concentration of the wiring line 3-2 having a size larger than the crystal grain size is defined as 0.5 to 10 wt%.

The final Cu concentration of the thick wiring line 3-2 can be set by defining the thickness of the Cu-based material 4 on the basis of the Cu concentration and the thickness of the Aℓ-Cu alloy 3 such that a desired concentration is obtained.

For example, 800-Å pure Cu (10Å = 1nm) is covered on a 1-fm thick Aℓ-0.1wt% Cu alloy, and the manufacturing process in Figs. 4 and 5 is performed to obtain a thin wiring line 3-1 having a Cu concentration of 0.1 wt%, and a thick wiring line 3-2 having a Cu concentration of 8 wt%, thereby obtaining an optimal resistance to electro-migration.

## Claims

1. A semiconductor device comprising wiring lines formed from an electrode wiring layer using, as an electrode material, an Aℓ alloy containing Cu, characterised in that wiring lines (3-1) having a width smaller than the crystal grain size of the wiring have a Cu concentration of 0.05 to 0.3 wt%, and wiring lines (3-2) having a width larger than the crystal grain size of the wiring have a Cu concentration of 0.5 to 10 wt%.

2. A method of forming a semiconductor device, in which wiring lines are formed from an electrode wiring layer using, as an electrode material, an Aℓ alloy containing Cu, characterised in that first wiring lines (3-1) having a width smaller than the crystal grain size of the wiring and having a Cu concentration of 0.05 to 0.3 wt% are formed in the same formation process as second wiring lines (3-2) having a width larger than the crystal grain size of the wiring and having a Cu concentration of 0.05 to 0.3 wt%, and the Cu concentration of the second wiring lines is then increased to 0.5 to 10 wt% by covering the second wiring lines with a Cu-based material and annealing to cause diffusion of the Cu-based material into the second wiring lines.

## Patentansprüche

1. Ein Halbleiterbauelement, umfassend Drahtleitungen, die aus einer Elektrodendrahtschicht ausgebildet sind, unter Verwendung einer Aℓ-Legierung, die Cu enthält, als Elektrodenmaterial
**dadurch gekennzeichnet, daß**
Drahtleitungen (3-1), die eine kleinere Breite als die Kristallkorngröße des Drahtes aufweisen, eine Cu-Konzentration von 0,05 bis 0,3 wt% aufweisen, und Drahtleitungen (3-2), die eine größere Breite als die Kristallkorngröße des Drahtes aufweisen, eine Cu-Konzentration von 0,5 bis 10 wt% aufweisen.

2. Ein Verfahren zum Bilden eines Halbleiterbauelements, in welchem Drahtleitungen aus einer Elektrodrahtschicht ausgebildet werden, unter Verwendung einer Aℓ-Legierung, die Cu enthält, als Elektrodenmaterial
**dadurch gekennzeichnet, daß**
erste Drahtleitungen (3-1), die eine kleinere Breite als die Kristallkorngröße des Drahtes aufweisen und eine Konzentration von 0,05 bis 0,3 wt% aufweisen, in dem gleichen Bildungsprozeß wie zweite Drahtleitungen (3-2), die eine größere Breite als die Kristallkorngröße des Drahtes aufweisen und eine Cu-Konzentration von 0,05 bis 0,3 wt% aufweisen, ausgebildet werden, und wobei die Cu-Konzentration der zweiten Drahtleitungen dann auf 0,5 bis 10wt% erhöht wird, durch Bedecken der zweiten Drahtleitungen mit einem auf Kupfer basierendem Material und durch Tempern, um eine Diffusion des auf Kupfer basierenden Materials in die zweiten Drahtleitungen bewirken.

## Revendications

1. Dispositif à semiconducteurs comprenant des fils de connexion formés à partir d'une couche de connexion d'électrode en utilisant, comme matériau d'électrode, un alliage de Aℓ contenant Cu, caractérisé en ce que des fils de connexion (3-1) ayant une largeur inférieure à la taille d'un grain de cristal du fil ont une concentration de Cu de 0,05 à 0,3 % en poids, et des fils de connexion (3-2) ayant une largeur supérieure à la taille d'un grain de cristal du fil ont une concentration de Cu de 0,5 à 10 % en poids.

2. Procédé de formation d'un dispositif à semiconducteurs, dans lequel des fils de connexion sont formés à partir d'une couche de connexion d'électrode en utilisant, comme matériau d'électrode, un alliage de Aℓ contenant Cu, caractérisé en ce que des premiers fils de connexion (3-1) ayant une largeur inférieure à la taille d'un grain de cristal du fil et ayant une concentration de Cu de 0,05 à 0,3 % en poids sont formés dans la même opération de formation que des seconds fils de connexion (3-2) ayant une largeur supérieure à la taille d'un grain de cristal du fil et ayant une concentration de Cu de 0,05 à 0,3 % en poids, et la concentration de Cu des seconds fils de connexion est ensuite augmentée jusqu'à 0,5 à 10 % en poids par recouvrement des seconds fils de connexion avec un matériau à base de Cu et recuit pour produire une diffusion du matériau à base de Cu jusque dans les seconds fils de connexion.
